# EUROPEAN PATENT APPLICATION

(11) **EP 4 811 036 A1**
(43) Date of publication of application: **23.09.2026**
(21) Application number: 25164450.6
(22) Date of filing: 18.03.2025
(51) Int. Cl.: G03F 7/00, G01N 21/95

(54) **PULSED RADIATION SOURCE AND METHOD OF ILLUMINATION**

(71) Applicant: ASML Netherlands B.V., 5500 AH Veldhoven (NL)
(72) Inventor: OP 'T ROOT, Wilhelmus, Patrick, Elisabeth, Maria, 5500 AH Veldhoven (NL); ZWIER, Olger, Victor, 5500 AH Veldhoven (NL); HINNEN, Paul, Christiaan, 5500 AH Veldhoven (NL); VAN DER ZOUW, Gerbrand, 5500 AH Veldhoven (NL); MATHIJSSEN, Simon, Gijsbert, Josephus, 5500 AH Veldhoven (NL); GIELISSEN, Kurt, 5500 AH Veldhoven (NL)
(74) Representative: ASML Netherlands B.V.

(57) **Abstract**

A metrology tool for measuring a target on a substrate, comprising a moveable substrate support configured to support the substrate and move the substrate at a first velocity. The metrology tool further comprises a radiation source configured to emit pulsed radiation to illuminate the target, and a detector configured to detect diffracted or reflected pulse radiation from the target to measure the target. The detector has a resolution such that a multiplication of the pulse length of the pulsed radiation and the first velocity is not greater than 2x the resolution.

## Description

### FIELD

The present invention relates to systems and apparatus for measurement of metrology targets on a substrate. Specifically it relates to measurement of metrology targets using a pulsed radiation source.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

In order to obtain the resolution the metrology or inspection tool is capable of, image data should be in focus. Factors that can impact the focus, such as vibrations, movement, changes in temperature, pressure, etc. may be controlled so as to reduce or minimize their impact on data collection.

### SUMMARY

According to an aspect of the current disclosure there is provided a metrology tool for measuring a target on a substrate. The tool comprises a moveable substrate support configured to support the substrate and move the substrate at a first velocity. The tool further comprises a radiation source configured to emit pulsed radiation to illuminate the target, wherein a pulse of the pulsed radiation has a pulse length, and a detector configured to detect diffracted or reflected pulse radiation from the target to measure the target, the detector having a resolution. A multiplication of the pulse length and the first velocity is not greater than 2x the resolution.

Optionally, the first velocity is a constant velocity at the time of illumination of the target.

Optionally, the first velocity matches an illumination velocity of the pulsed radiation.

Optionally, the multiplication of the pulse length and the first velocity is not greater than 1.5x the resolution, or not greater than 1.2x the resolution, or not greater than 1.0x the resolution.

Optionally, the pulsed radiation comprises one or more wavelengths in a range of 400 nm - 900 nm, or 400 nm - 1500 nm or 400 nm - 2000 nm.

Optionally, the radiation source is tunable to emit one or more wavelengths.

Optionally, the radiation source is configured to illuminate the target with a first wavelength.

Optionally, the radiation source is configured to illuminate the target with a first wavelength and a second wavelength.

Optionally, the metrology tool comprises a grating light valve positioned between the radiation source and the target.

Optionally, the radiation pulse has a radiation pulse energy such that a portion of the radiation that is incident on the detector from the target has a signal-to-noise ratio above 1.

Optionally, the radiation pulse has a radiation pulse energy such that a portion of the radiation that is incident on the detector generates a signal that is measurable over an electron-shot-noise variation of the detector.

Optionally, the radiation pulse has a pulse energy that is at least 6µJ.

Optionally, the pulsed radiation has an average power of at least 6mW.

Optionally, the radiation source is configured to emit the pulsed radiation with a pulse frequency that matches a readout duration of a single detector frame of the detector.

Optionally, the radiation source is configured to emit the pulsed radiation with a pulse frequency in a range of 1000 - 2000 radiation pulses per minute.

Optionally, the pulse length is in a range of 0.05 - 0.2 µs, or 0.1 µs - 1.0 µs.

Optionally, the substrate is configured to be moved to a plurality of positions to illuminate a plurality of targets on the substrate.

Optionally, the substrate is configured to be moved in a two-dimensional pattern.

Optionally, the substrate is configured to be moved in a three-dimensional pattern.

Optionally, the detector is configured to be moved in a two-dimensional pattern.

Optionally, the detector is configured to be moved in a three-dimensional pattern.

Optionally, the first resolution is equal to or smaller than a wavelength λ of the radiation divided by 2 times the numerical aperture NA, $\frac{λ}{2 NA}$.

Optionally, the numerical aperture has a value in a range of 0.95 or less.

Optionally, the first resolution is in a range of 0.5 µm - 1.5 µm.

Optionally, the first resolution is 1.0 µm.

Optionally, the first velocity is in a range of 1 m/s - 2 m/s.

Optionally, measuring the target include one or more of overlay, alignment, critical dimension, dose, or focus.

Optionally, the radiation source illuminates the target such that the target is overfilled.

Optionally, the target comprises one or more diffraction gratings

Optionally, the target comprises a diffraction grating in a first direction.

Optionally, the target comprises a diffraction grating in a second direction that is non-parallel or perpendicular to the first direction.

According to another aspect of the current disclosure there is provided an inspection tool comprising a metrology tool as described herein.

According to another aspect of the current disclosure there is provided a litho cell comprising a metrology tool or inspection tool as described herein.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a simplified schematic representation of a metrology tool; and
- Figures 9(a) and 9(b) depict schematic graphs depicting substrate velocity and illumination as a function of time for different metrology tools.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

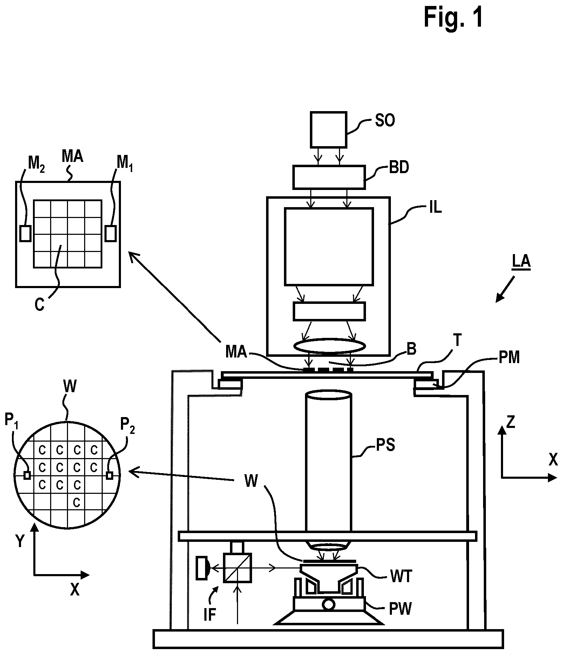

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

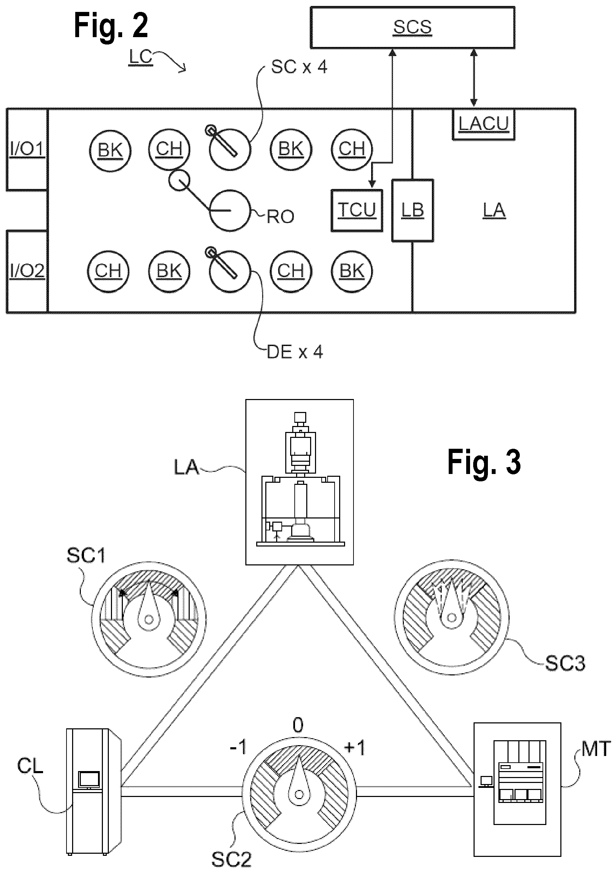

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

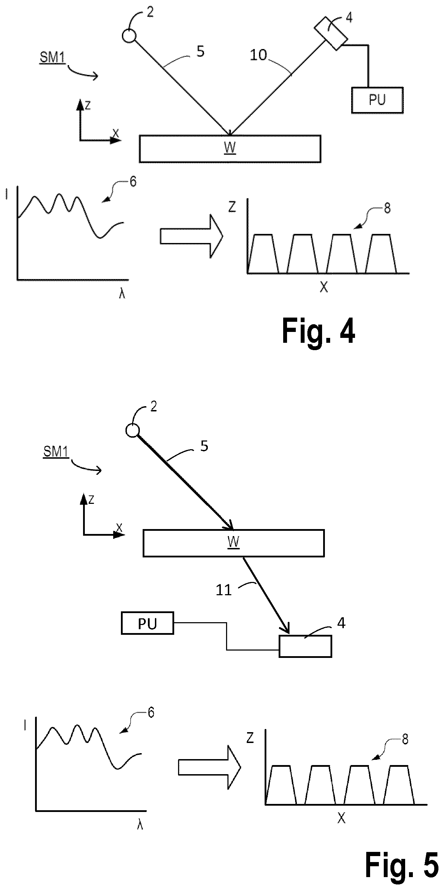

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

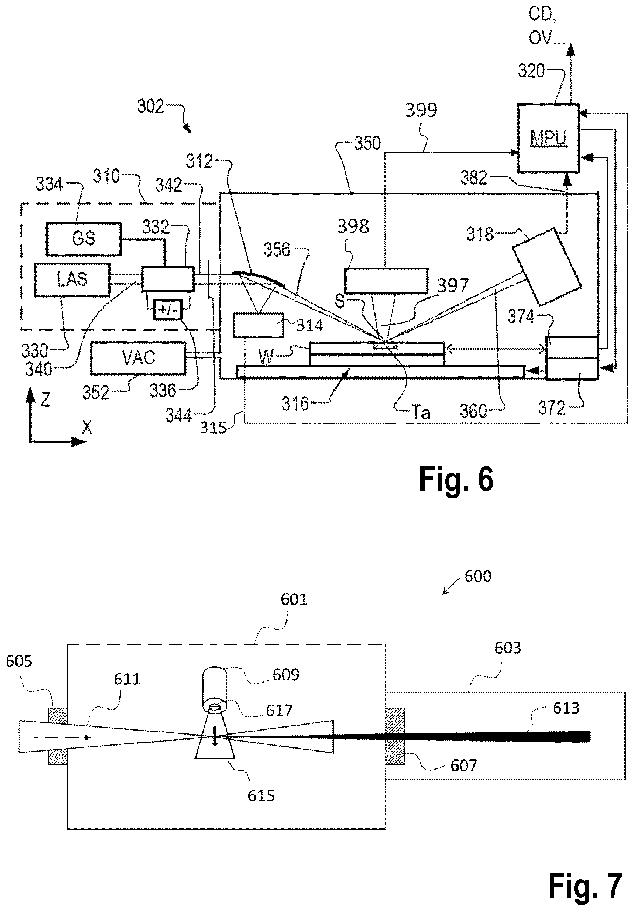

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus.The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

Discussed herein are systems, tools, and apparatus which perform high-resolution tasks, which may be in lithography, metrology, inspection, etc. The metrology data may include image data, which may comprise one or more images. The image data may be obtained of a target. Obtaining image data may also be referred to as acquiring image data. In the context of this disclosure, these terms may be interpreted as substantially having the same meaning. In order to acquire high-resolution image data, a high-resolution metrology system may be used. This may involve a complex and cost-intensive setup using advanced optics (e.g. objectives mirrors), radiation source(s), and detection systems.

A metrology setup may comprise (non-exhaustively) a radiation source for providing radiation, and an optical assembly for receiving, shaping, controlling, and guiding the radiation from the source to illuminate a target to be measured. The radiation may be configured to irradiate and interact with the target. Interaction with the target may include one or more of reflection, transmission, absorption, diffraction, etc. The metrology setup may also comprise a substrate support, configured for holding the target, and a detection assembly which may be positioned and configured to receive at least some of the radiation that has interacted with the target. This detected radiation may be analysed to determine one or more properties or features of the target and/or the metrology environment. The target may be a metrology target located on a substrate, such as a semiconductor wafer. The target may comprise one or more structures (e.g. diffraction gratings) that have been lithographically patterned onto the semiconductor substrate. A substrate may comprise a plurality of targets, for example 10 - 100 targets.

In order to optimize or improve a resolution of acquired image data, measurement conditions may be controlled to not adversely affect the acquisition of data. Measurement conditions may for example include environmental conditions such as temperature and pressure. Measurement conditions may also include conditions of the metrology system, tool, apparatus, and components thereof. The components may include for example a radiation source, substrate support, optical assembly, detector, sensor, measurement target, etc. as described above. An example of controlling measurement conditions may include acquiring metrology data when the target has zero velocity. This may be to avoid any blur that may be introduced as a result of movement.

Several disadvantages may be associated with having a substrate at zero velocity. It may be desirable to move the substrate inside the metrology tool, for example to amend the position of the substrate for measuring different targets on the substrate. This may be because generally the metrology tool is only able to measure a small portion of the substrate at one time, and movement to a different location of the substrate is required to measure a different portion of the substrate. A disadvantage of acquiring measurement data at zero velocity may be that the substrate support (and substrate carried on it) do not reach the highest possible velocity of the substrate support. This may be because of the limited duration between measurement acquisitions. Not achieving the highest velocity may result in a throughput penalty. Another disadvantage associated with acquiring metrology at zero velocity may be that the forces needed to accelerate/de-accelerate the substrate support may induce vibrations inside the metrology tool. These vibrations may for example be of the substrate and/or of the optical assembly. The vibrations may introduce image blur. To mitigate the potential introduction of blur, additional settling time may be taken for vibrations to dissipate, which may have a further throughput cost/penalty. Furthermore, as the substrate support is not moving between metrology acquisition positions during image acquisition and/or during settling time, this may further negatively affect throughput.

While having a substrate at zero velocity may have disadvantages as described above associated with it, existing setups may not be suitable for measuring a moving substrate. The current disclosure provides solutions for overcoming challenges associated with measuring a substrate configured to be moved between different positions.

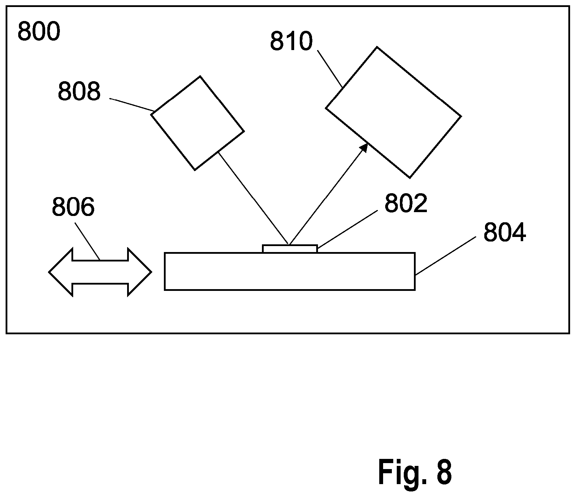

Figure 8 depicts a schematic representation of a metrology tool 800 for measuring a target on a substrate 802. The metrology tool 800 comprises a moveable substrate support 804 configured to support the substrate 802. The substrate support is configured to move 806 the substrate at a first velocity. The metrology tool further comprises a radiation source 808 configured to emit pulsed radiation for illuminating a target on the substrate 802. The pulsed radiation may comprise a plurality of pulses, wherein each pulse has a pulse length. The metrology tool 800 further comprises a detector 810 configured to detect radiation that has interacted with the target. The radiation detected by the detector may have been diffracted and/or reflected by the target on the substrate 802. The detector has a resolution, wherein a resolution may be understood as the smallest possible size of detail that can be observed by the detector. The values of the pulse length and first velocity are such that their product (multiplication) is around the same order of magnitude of the resolution of the detector. The product of the first velocity and the pule length may be not greater than twice (2x, 2 times) the value of the resolution.

The first velocity of the substrate may be substantially constant. The velocity of the substrate may be constant while the radiation pulse is emitted/illuminating the target on the substrate. The movement of the substrate may be along a trajectory, wherein the trajectory may move in such a way that the plurality of targets become located in the path of the radiation beam for measuring. While the velocity of the substrate may be substantially constant while covering the trajectory, the movement of the substrate may involve one or more changes in direction, which may have small and temporary changes in velocity associated with it. These changes in direction and/or velocity may occur at a time when the substrate is not being illuminated for measurement (e.g. between radiation pulses). The velocity may be a result of the substrate changing position such that different targets on the substrate become located in a position in which they can be illuminated by a radiation pulse. A trajectory to be taken by the substrate to move between targets may be determined algorithmically. The determination may be based on one or more conditions, such as avoiding sharp corners, and achieving a short route between all targets to be measured. The one or more conditions may assist in achieving a faster average velocity for the substrate, and therefore an increased throughput. The trajectory determination may be specific to a layout of targets on a substrate.

An advantage of a metrology tool as described herein may be that the amount the target moves during the duration of the radiation pulse is small enough compared to the resolution of the detector that the effects of the movement on the obtained measurement data are limited. This enables the metrology tool 800 to obtain measurements of the target when the substrate has a constant velocity. This may lead to an increased throughput of measurements. It may for example lead to a doubling or tripling of the amount of measurements that can be obtained of different targets.

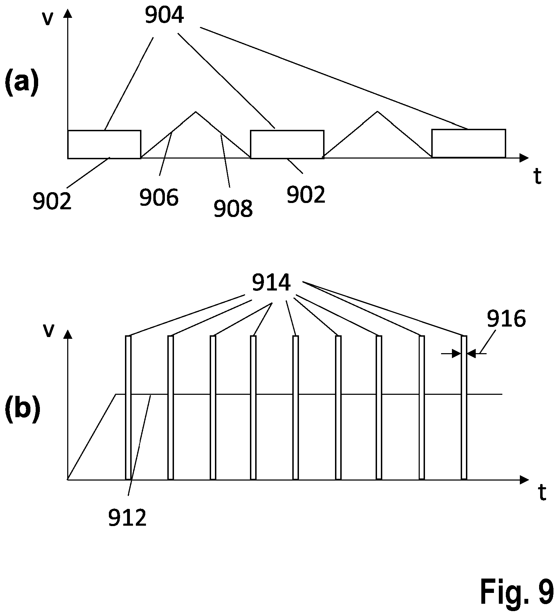

Figure 9 depicts illustrative schematic graphs showing a throughput improvement for a metrology setup where the target and substrate move with a constant velocity compared to a setup where a target is measured at zero velocity. Graph 9(a) shows substrate velocity and illumination for an existing technology in which the substrate moves between different target measurement locations. In the depicted example, the substrate and target have a varying velocity v over time t. The substrate is stationary 902 (velocity = 0) while a target is at the measurement location. At this point the radiation source is turned on 904, and one or more measurements are obtained. Once the measurements have finalised, the substrate accelerates 906 to move to a next target location. It decelerates 908 and comes to a halt 902 at the next target location and the radiation source is turned on 904 for the next target measurement(s). This process may be repeated for all targets on the substrate.

Graph 9(b) depicts example substrate velocity and illumination using a metrology tool as described in relation to figure 8. In the example illustration, the substrate moves with a constant velocity 912 and a short radiation pulse 914 is used to illuminate targets. At the beginning of the timelines, a ramp-up from 0 velocity to the constant velocity may be depicted. The systems of the metrology tool 8 may be set up to align/match the timing of the radiation pulses 914 with the location of the target at the measurement location. Each pulse 914 may correspond to a measurement obtained by the metrology tool. As can be seen from a comparison of graphs 9(a) and 9(b), in the setup (b) where the target has a constant velocity, a higher number of measurements can be performed in the same amount of time, allowing a higher throughput. As stated above, the pulse length 916 of the radiation pulse may be such that a product of the pulse length tₚ and the substrate velocity vₛ is not more than twice the resolution r_{d} of the detector: velocity vₛ x pulse length tₚ ≤ 2 x resolution r_{d}.

While the condition on the pulse length relative to the resolution of the detector and the velocity of the substrate is described above as : vₛ x tₚ ≤ 2 x r_{d}, the requirement may be that the product is small enough for the amount of movement to not have a big impact on the resolution of the acquired measurement. Instead of twice the resolution, it could be the order of magnitude of the resolution, 1.5 times (1.5x) the resolution, 1.2 times (1.2x) the resolution, 1 times (1x) the resolution, or smaller than the resolution. In some instances, the metrology tool settings may be such that the product of the velocity of the substrate and the pulse length is significantly smaller than the resolution of the detector: velocity vₛ x pulse length tₚ << 2 x resolution r_{d}.

The radiation source may have several different properties that determine its performance, including wavelength, pulse length, pulse energy, peak pulse power, pulse duration, average power, etc. These properties may interact and depend on each other, and may affect the functioning of the radiation source. Some of these properties of the radiation source, and their effects on the measurement setup will be discussed in more detail below. The radiation source may emit pulsed radiation at one or more wavelengths. The pulsed radiation used for illuminating and measuring a substrate may comprise one or more wavelengths in a range of 400 nm - 900 nm, or 400 nm - 1500 nm, or 400 nm - 2000 nm. In some embodiments, the pulsed radiation emitted by the radiation source may be tunable to emit one or more wavelengths in a tunable range of 400 nm - 900 nm, or 400 nm - 1500 nm or 400 nm - 2000 nm. The wavelength may be tuned for example based on features of the target to be illuminated.

The radiation source may emit radiation pulses with sufficient energy for the measurement to be performed. The energy of a radiation pulse may be suitable for measurement if the detector is able to distinguish the signal of the detected radiation. For example, the energy of a radiation pulse may be high enough such that the electron-shot-noise variation of the detector read-out does not limit the total measurement uncertainty. This may for example be achieved if the measured signal has a higher intensity than the electron shot noise of the detector. More generally, the radiation pulse energy may be such that the portion of the radiation that is incident on the detector generates a signal that is measurable over an electron-shot-noise variation of the detector. The radiation pulse energy may be such that the signal detected by the detector has signal-to-noise ratio above 1. The above shot-noise or signal-to-noise ratio requirements may set a lower limit to the radiation pulse energy, which may also be referred to as a lower threshold. An upper limit of the radiation pulse energy may be determined based on for example source capacity, or thermal tolerances in the measurement system. For example, the radiation pulse energy may have an energy low enough to avoid or substantially limit radiation-induced damage (e.g. thermal damage) to components interacting with the radiation. A pulse stretcher may be provided after the radiation source output to lower a peak intensity of the pulse if it is considered too high, and risks causing damage.

A numerical value or range for the radiation pulse energy may depend on the properties of the components of the metrology tool as set out above. In an example embodiment, the radiation pulse energy may be at least 6µJ. Depending on the components used, the value may be lower or higher. The radiation source may have an average power that is determined by the radiation pulse energy and the pulse repetition rate. The radiation source may have a pulse repetition rate such that the pulse frequency matches a readout duration of a single detector frame of the detector. The radiation source may emit pulsed radiation with a pulse frequency up to 1 pulse / ms. The radiation source may have for example an average output energy of at least 6mW.

The pulse length of a radiation source may be interrelated to the pulse energy and the resolution of the. A longer duration of the pulse length may have a bigger effect on the resolution of the resulting measurement of a moving target, as the distance covered by the moving target increases linearly with pulse duration, providing the velocity of the target is constant. The velocity of the moving target during measurement may be referred to as a first velocity. The first velocity of the substrate may be a constant velocity at a time of illumination of the target. The velocity may be substantially constant while the substrate is moving. The velocity may change for example when the movement of the substrate changes direction. The first velocity may for example be in a range of 1 m/s - 2 m/s. The first velocity may match an illumination velocity of the pulsed radiation. A pulse length may be in a range of 0.05 µs - 1.0 µs, or preferably in a range of 0.05 µs - 0.2 µs. These pulse length values are provided as an example only, and other pulse lengths are possible, depending on the other properties of the radiation source, detector, and moving target.

The substrate may comprise a plurality of targets to be measured. The substrate may be configured to be moved to a plurality of different positions to illuminate some or all of the plurality of the targets of the substrate successively. The substrate may be configured to be moved in a two-dimensional pattern. The two-dimensional pattern may be in a plane parallel to a plane of the substrate. The two-dimensional pattern may include a path along the substrate to measure a plurality of targets on the substrate. In some instances, the substrate may be moved in a three-dimensional pattern. This may include a move along the two-dimensional pattern in plane parallel to a plane of the substrate, as well as a movement in a third dimension perpendicular to this plane. This movement in a third direction perpendicular to a plane of the substrate may for example be to measure a target in different planes (also referred to as at different depths) of the substrate. In some instances, the detector may be moved in a three-dimensional pattern, or in a two-dimensional pattern. The size of the radiation spot in the plane of the target on the substrate may be larger than the substrate, such that the illuminated target to be measured is overfilled. In some other embodiments, the target may be underfilled, in which the radiation spot does not cover the whole surface area of the target.

The resolution of the detector may be diffraction limited. The resolution may be understood as the size of the smallest distinguishable detail d being equal to the wavelength of the radiation λ divided by two times the numerical aperture NA of the detector system: $d = \frac{λ}{2 NA}$. The numerical aperture may have a value in a range of 0.95 or less, NA ≤ 0.95. The resolution of the detector may for example be in a range of 0.5 µm - 1.5 µm. The resolution of the detector may for example be of the order of 1 µm, or equal to 1 µm.

Paragraphs above describe properties of different elements of the metrology tool for measuring a target on a substrate. Measuring the target may include measuring one or more of overlay, alignment, critical dimension, dose of litho cell, and/or focus of litho cell. The substrate may comprise a plurality of targets. For example, a substrate may comprise in a range of 100 - 5000 targets. However, substrates with more or fewer targets may also be provided. A metrology tool may measure some or all targets on a substrate. A target may be a structure patterned onto the substrate with a specific purpose of allowing measurement for determining one or more properties of the target. The measurements may provide information for example about the substrate, the patterning process, and/or the resulting patterns on the substrate other than the metrology targets. This may for example be used for inspecting quality of the patterned substrate, updating or adjusting the patterning process, performing predictive maintenance, etc.

A metrology target may comprise one or more diffracting structures, or reflecting structures. A diffracting structure may for example be a diffraction grating. A diffraction grating may comprise a plurality of parallel lines in a plane of the substrate. A metrology target may comprise a diffraction grating in a first direction. In some embodiments, the target may comprise a second diffraction grating in a second direction, in which the second direction is non-parallel to the first direction. The first direction and second direction may be in a plane of the substrate. In some embodiments, different diffraction gratings may be placed side by side in a plane of the substrate. In some embodiments, different targets may be stacked on top of each other in different layers of the substrate. The periodicity of a diffraction grating on the substrate may be set to correspond to a wavelength of the radiation source used for measuring (or for a tunable source, the radiation wavelength may be tuned to the periodicity of the diffraction grating).

In some embodiments a target with two or more diffraction gratings may have each grating with substantially the same periodicity, such that each target may be measured using the same radiation wavelength. In some embodiments, a target with two or more diffraction gratings may have gratings with different periodicities, to be measures by different wavelengths. In order to achieve this a radiation source may emit two or more different wavelengths. The two or more wavelengths may be emitted simultaneously or successively. A grating light valve may be positioned between the radiation source and the target to be measured, for example to direct radiation in different directions towards the substrate. The radiation directed in different directions may for example have different wavelengths.

Whilst the description above is provided for diffraction gratings herein for ease of description, a target may alternatively or additionally comprise a different diffracting structures and/or reflecting structures.

In some embodiments the metrology tool may illuminate a target with a single wavelength, which may be referred to as a first wavelength. In some embodiments the metrology tool may illuminate a target with two different wavelengths, which may be referred to as a first wavelength and a second wavelength. In some further embodiments the metrology tool may illuminate a target with more than two wavelengths, which may be referred to as third, fourth, etc wavelengths accordingly. In some embodiments, the metrology tool may illuminate a target with a radiation plurality of different polarizations. Different wavelengths and/or different polarizations may enable multiple separate measurements to be obtained fully or partially overlapping in time and/or pace.

When using a metrology tool with a radiation source outputting multiple wavelengths and/or polarisations, it may be advantageous to introduce a radiation beam pattern comprising 2 or more spots at separate locations in the plane of the substrate (i.e. not overlap). The plurality of spots may be separate from each other in a range of a few microns (e.g. 1 - 5 µm). If each radiation spot consists of light having a single wavelength and/or polarisation, it may be possible to perform acquisitions at different wavelengths and/or polarisations respectively simultaneously. that is to say, without having to rerun the trajectory of the moving substrate. A grating light valve may be used to create pulses and/or spots, each pulse/spot having a multi-wavelength spectrum with tunable weights. Electro-optic radiation manipulators may be used to modify polarisation of radiation pulses in a timeframe of the order of microseconds. In some instances electro-optic radiation manipulators may modify wavelength of the radiation pulse. A grating light valve and/or an electro-optic radiation manipulator may be used to perform measurements at more wavelengths/polarisations during the same run of the trajectory of the moving substrate. A hyperspectral camera may be used in combination with a grating light valve to enable parallel multi-wavelength illumination.

A target on the substrate to be measured may be overfilled by the radiation beam measuring it. In an example embodiment, provided for illustration purposes only, a pulsed radiation source may have a repetition rate of 1 MHz, and the substrate may have a velocity of 1.5m/s. In such a setup, the distance moved by the substrate between two subsequent pulses may be in the range of 0.7 µm. This distance travelled between pulses may be less than the size of a radiation beam spot incident on the wafer. A radiation beam spot, which may be understood to be an area of the substrate covered by the radiation beam in the plane of the substrate, may have a diameter size up to several 10s of µm. For example, a radiation beam spot may have a diameter in a range of 1 µm - 50 µm, or 5 µm to 40 µm. This size is significantly larger than the distance between targets on the substrate, meaning the radiation beam may illuminate neighbouring targets to the target to be measured. This poses a risk of accidentally capturing or detecting radiation diffracted from neighbouring structures, which would be undesirable.

In order to solve this problem and avoid radiation of a pulsed radiation beam interacting with neighbouring structures, the radiation spot size may be adjusted based on the size of the target on the substrate. Adjustment may be performed for example using beam shaping optics to change the size of the spot and/or apertures or beam blocking elements that block a part of the radiation such that the resulting size of the spot is reduced. The adjustment of spot size may be adjusted such that the size of the radiation spot in the plane of the target just overfills the target, for example with an overfill having a margin in a range of 1 µm to 4 µm, or 1 µm to 2 µm. While a measurement using an overfilled target described herein, this is not a necessary requirement, and an underfilled measurement would also be possible.

The close proximity between the subsequent measurements on the substrate may also be used to perform a synchronization between the movement of the substrate and the timings of the pulses. This may be useful for aligning the radiation pulse spots with the target locations. Using the example of 1MHz pulse rate and 1.5 m/s substrate velocity above, when a measurement is made with each radiation pulse, three subsequent measurements may be obtained in an area around a target with a moving distance of approximately 1.4 µm. Taking the second of three measurement as the measurement aligned with the target, the three measurements may be located as -0.7 µm, 0 µm, and +0.7 µm. Analysing the three measurements, target recognition software may be implemented to identify the obtained image with the lowest target position offset.

Target recognition software may compare obtained measurement data to a reference, wherein the reference may be determined (e.g. calculated, modelled, estimated) based on an ideal measurement. The reference may be determined as the target structure, source properties, and detector properties are all known. The software may then compare the actual measured data to the reference, and based on the comparison may determine how close reference is to each of the -0.7 µm, 0 µm, and +0.7 µm obtained images. The substrate velocity may be adjusted based on the results of the comparison, to better align the radiation pulse and measurement with the target position when the measurement is obtained. This may also be referred to as synchronization between the source and the substrate movement. Synchronization calculations may be performed intermittently or continuously for example to adjust for drift and/or errors.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the following list of numbered clauses:
1. A metrology tool for measuring a target on a substrate, the tool comprising:
   a moveable substrate support configured to support the substrate and move the substrate at a first velocity;
   a radiation source configured to emit pulsed radiation to illuminate the target, wherein a pulse of the pulsed radiation has a pulse length; and
   a detector configured to detect diffracted or reflected pulse radiation from the target to measure the target, the detector having a resolution; and
   wherein a multiplication of the pulse length and the first velocity is not greater than 2x the resolution.
2. A metrology tool according to clause 1, wherein the first velocity is a constant velocity at the time of illumination of the target.
3. A metrology tool according to any of the preceding clauses, wherein the first velocity matches an illumination velocity of the pulsed radiation.
4. A metrology tool according to any of the preceding clauses, wherein the multiplication of the pulse length and the first velocity is not greater than 1.5x the resolution, or not greater than 1.2x the resolution, or not greater than 1.0x the resolution.
5. A metrology tool according to any of the preceding clauses, wherein the pulsed radiation comprises one or more wavelengths in a range of 400 nm - 900 nm, or 400 nm - 1500 nm or 400 nm - 2000 nm.
6. A metrology tool according to any of the preceding clauses, wherein the radiation source is tunable to emit one or more wavelengths.
7. A metrology tool according to any of the preceding clauses, wherein the radiation source is configured to illuminate the target with a first wavelength.
8. A metrology tool according to any of the preceding clauses, wherein the radiation source is configured to illuminate the target with a first wavelength and a second wavelength.
9. A metrology tool according to any of the preceding clauses, wherein the metrology tool comprises a grating light valve positioned between the radiation source and the target.
10. A metrology tool according to any of the preceding clauses, wherein the radiation pulse has a radiation pulse energy such that a portion of the radiation that is incident on the detector from the target has a signal-to-noise ratio above 1.
11. A metrology tool according to clause 10, wherein the radiation pulse has a radiation pulse energy such that a portion of the radiation that is incident on the detector generates a signal that is measurable over an electron-shot-noise variation of the detector.
12. A metrology tool according to any of the preceding clauses, wherein the radiation pulse has a pulse energy that is at least 6µJ.
13. A metrology tool according to any of the preceding clauses, wherein the pulsed radiation has an average power of at least 6mW.
14. A metrology tool according to any of the preceding clauses, wherein the radiation source is configured to emit the pulsed radiation with a pulse frequency that matches a readout duration of a single detector frame of the detector.
15. A metrology tool according to any of the preceding clauses, wherein the radiation source is configured to emit the pulsed radiation with a pulse frequency up to 1 pulse per millisecond ms.
16. A metrology tool according to any of the preceding clauses, wherein the pulse length is in a range of 0.05 - 0.2 µs, or 0.1 µs - 1.0 µs.
17. A metrology tool according to any of the preceding clauses, wherein the substrate is configured to be moved to a plurality of positions to illuminate a plurality of targets on the substrate.
18. A metrology tool according to any of the preceding clauses, wherein the substrate is configured to be moved in a two-dimensional pattern, or wherein the substrate is configured to be moved in a three-dimensional pattern.
19. A metrology tool according to any of the preceding clauses, wherein the detector is configured to be moved in a three-dimensional pattern.
20. A metrology tool according to any of the preceding clauses, wherein the first resolution is equal to or smaller than a wavelength λ of the radiation divided by 2 times the numerical aperture NA, $\frac{λ}{2 NA}$.
21. A metrology tool according to clause 20, wherein the numerical aperture has a value in a range of 0.95 or less.
22. A metrology tool according to any of the preceding clauses, wherein the first resolution is in a range of 0.5 µm - 1.5 µm.
23. A metrology tool according to any of the preceding clauses, wherein the first resolution is 1.0 µm.
24. A metrology tool according to any of the preceding clauses, wherein the first velocity is in a range of 1 m/s - 2 m/s.
25. A metrology tool according to any of the preceding clauses, wherein measuring the target include one or more of overlay, alignment, critical dimension, dose, or focus.
26. A metrology tool according to any of the preceding clauses, wherein the radiation source illuminates the target such that the target is overfilled.
27. A metrology tool according to any of the preceding clauses, wherein the target comprises one or more diffraction gratings
28. A metrology tool according to clause 27, wherein the target comprises a diffraction grating in a first direction.
29. A metrology tool according to clause 28, wherein the target comprises a diffraction grating in a second direction that is non-parallel or perpendicular to the first direction.
30. An inspection tool comprising a metrology tool according to any of the preceding clauses
31. A litho cell comprising a metrology tool or inspection tool according to any of the preceding clauses.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.
Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A metrology tool for measuring a target on a substrate, the tool comprising:
a moveable substrate support configured to support the substrate and move the substrate at a first velocity;
a radiation source configured to emit pulsed radiation to illuminate the target, wherein a pulse of the pulsed radiation has a pulse length; and
a detector configured to detect diffracted or reflected pulse radiation from the target to measure the target, the detector having a resolution; and
wherein a multiplication of the pulse length and the first velocity is not greater than 2x the resolution.

2. A metrology tool according to claim 1, wherein the first velocity is a constant velocity at the time of illumination of the target.

3. A metrology tool according to any of the preceding claims, wherein the first velocity matches an illumination velocity of the pulsed radiation.

4. A metrology tool according to any of the preceding claims, wherein the radiation source is tunable to emit one or more wavelengths.

5. A metrology tool according to any of the preceding claims, wherein the metrology tool comprises a grating light valve positioned between the radiation source and the target.

6. A metrology tool according to any of the preceding claims, wherein the radiation pulse has a radiation pulse energy such that a portion of the radiation that is incident on the detector from the target has a signal-to-noise ratio above 1.

7. A metrology tool according to claim 6, wherein the radiation pulse has a radiation pulse energy such that a portion of the radiation that is incident on the detector generates a signal that is measurable over an electron-shot-noise variation of the detector.

8. A metrology tool according to any of the preceding claims, wherein the radiation pulse has a pulse energy that is at least 6µJ.

9. A metrology tool according to any of the preceding claims, wherein the radiation source is configured to emit the pulsed radiation with a pulse frequency that matches a readout duration of a single detector frame of the detector.

10. A metrology tool according to any of the preceding claims, wherein the radiation source is configured to emit the pulsed radiation with a pulse frequency up to 1 pulse per millisecond.

11. A metrology tool according to any of the preceding claims, wherein the substrate is configured to be moved to a plurality of positions to illuminate a plurality of targets on the substrate.

12. A metrology tool according to any of the preceding claims, wherein the first resolution is equal to or smaller than a wavelength λ of the radiation divided by 2 times the numerical aperture NA, $\frac{λ}{2 NA}$.

13. A metrology tool according to any of the preceding claims, wherein the radiation source illuminates the target such that the target is overfilled.

14. An inspection tool comprising a metrology tool according to any of the preceding claims.

15. A litho cell comprising a metrology tool or inspection tool according to any of the preceding claims.
